# EUROPÄISCHE PATENTSCHRIFT

(11) **EP 0 592 993 B1**
(45) Veröffentlichungstag und Bekanntmachung des Hinweises auf die Patenterteilung: **29.07.1998**
(21) Anmeldenummer: 93116456.0
(22) Anmeldetag: 11.10.1993
(51) Int. Cl.: H03M 7/30, H03M 7/50, G06F 5/01

(54) **Schaltungsanordnung zum Umwandeln von digitalen Tonsignalen**
Circuit for converting digital audio signals
Dispositif de conversion de signaux audio numériques

(30) Priorität: 12.10.1992 DE 4234341
(43) Veröffentlichungstag der Anmeldung: 20.04.1994
(73) Patentinhaber: SIEMENS AKTIENGESELLSCHAFT, 80333 München (DE)
(72) Erfinder: Köllner, Herbert, Ing. grad., D-83607 Holzkirchen (DE)

(56) Entgegenhaltungen:
- FR-A- 2 612 024
- GB-A- 2 090 447
- US-A- 4 149 263
- U.TIETZE;CH.SCHENK 'halbleiter-schaltungtechnik' Januar 1990 , SPRINGER-VERLAG , BERLIN-HEIDELBERG (DE) * Seite 601, Absatz 19.3 - Seite 603; Abbildung 19.13 *
- ELEKTRONIK, Bd. 35, Nr. 6, März 1986 MUNCHEN DE, Seiten 65-70, K.SCHRÄDER 'schnellste daten-bit-manipulationen mit barrel-shiftern'

## Beschreibung

Die Erfindung betrifft eine Schaltungsanordnung zum Umwandeln von digitalen Tonsignalen in ihr ursprüngliches Datenformat, wobei die digitalen Tonsignale mit einem gemeinsamen digitalen Skalenfaktor zum Einsparen redundanter Bitstellen empfangen werden.

Eine solche Schaltungsanordnung ist beispielsweise aus der EP 0 133 697 A2 sowie der DD 250 420 Al bekannt. Diese bekannten Schaltungsanordnungen dienen zum Dekomprimieren von komprimiert übertragenen Tonsignalen im Rundfunk, insbesondere Satelliten-Direkt-Rundfunk. Bei einer derartigen Übertragung werden die Abtastwerte der digitalen Tonsignale in Blöcke eingeteilt und für jeden Block ein Skalenfaktor ermittelt, der angibt in welchem Amplitudenbereich der größte Abtastwert eines Blockes liegt. Bezogen auf den Zweier-Komplement-Code gibt der Skalenfaktor somit an, wie viele der den Vorzeichenbit folgenden Bits in allen Abtastwörtern des Blockes den gleichen Wert wie das Vorzeichenbit haben. Wird der Skalenfaktor mitübertragen, so kann auf die durch ihn gekennzeichnete Redundanz in den Abtastwörtern bei der Übertragung verzichtet und ihre relevante Information des an die Vorzeichenbits herausgeschoben werden. Dadurch ist es bei niedrigen Signalamplituden möglich, z. B. auch die 15ten und 16ten Bits der Quellcodewörter mitzuübertragen (sog. 16/14-Bit-Gleitkommatechnik). Außerdem werden bei leisen Tonpassagen mögliche Amplitudenfehler, die von Bitfedern im redundanten Teil der Abtastwörter herrühren, vermieden. Gemäß einem Normvorschlag für den für den Satelliten-Direkt-Rundfunk wird die Gleitkommatechnik benutzt und ein 3-Bit-Skalenfaktor (entsprechend 8 Amplitudenbereichen) vorgeschlagen sowie eine Blocklänge von 64 Abtastwerten vorgesehen. Pro Block braucht der Skalenfaktor nur einmal für jeden der beiden Stereokanäle (L, R) übertragen zu werden.

Prinzipiell kann ein derartiges Verfahren auch bei terrestrischen drahtlosen oder drahtgebundenen Übertragungen von digitalisierten Tonsignalen angewandt werden.

Im Empfänger müssen die Bits der nach diesem Verfahren übertragenen Abtastwerte mit Hilfe des mitübertragenden Skalenfaktors wieder in die Lage zurückgeschoben werden, die ihrer ursprünglichen Wertigkeit entspricht. Dazu wird in der EP 0 133 697 A2 vorgeschlagen, daß das jeweils als erstes Bit (MSB) eines Wortes übertragene Vorzeichenbit von einem Eingang 1 für die übertragenen Abtastwörter in ein Schieberegister 2 übernommen und durch einen Steuerbefehl einer nicht näher beschriebenen Ablaufsteuerung 3 in eine erste Speichereinrichtung 4 eingelesen wird. Danach wird durch eine dem Skalenfaktor entsprechende Anzahl von Takten der Ablaufsteuerung 3 das Vorzeichenbit in der Speichereinrichtung 4 vervielfacht. Hierzu wird der an einen zweiten Eingang 5 zur Verfügung stehende und in einer zweiten Speichereinrichtung 6 gespeicherte Skalenfaktor der Ablaufsteuerung 3 zugeführt. Anschließend werden die restlichen Bits des Tonsignalabtastwortes vom Schieberegister 2 in die Speichereinrichtung 4 geschoben, in ein paralleles Format gebracht und einem D/A-Wandler 7 formatgerecht zugeführt, so daß an einem Ausgang 8 das Tonsignal abgenommen werden kann.

Ein anderes Verfahren zum Umwandeln der empfangenen Bits ist in der DD 250 420 Al beschrieben. Dort wird nachdem das übertragene Abtastwort in ein Schieberegister eingelesen wird, ein zweites nachgeschaltetes Schieberegister entsprechender Zellenzahl mit den Vorzeichenbits gefüllt. Danach erfolgt eine Verschiebeoperation zum Ausgang des zweiten Schieberegisters hin, so daß das rekonstruierte Abtastwort abgegriffen werden kann. Derartige Schaltungsanordnungen erfordern aber eine serielle Verarbeitung der Tonsignale, was einen hohen Aufwand an Steuerlogik bedingt.

In der GB 2 090 447 A ist eine Vorrichtung zum Verschieben von Bit-Mustern beschrieben, die fünf Stufen aufweist. Die Stufen sind miteinander verbunden. Die Anzahl der zu verschiebenden Bit-Stellen wird von einem Skalenfaktor bestimmt. Durch die Verschiebung frei gewordene Stellen werden mit Nullen aufgefüllt.

Aus dem Buch "Halbleiter-Schattungstechnik" von U. Tietze und Ch. Schenk, 9. Auflage 1990, sind sogenannte Kombinatorische Schieberegister bekannt, die ausschließlich aus Multiplexern aufgebaut sind.

Aufgabe der vorliegenden Erfindung ist es deshalb, eine gattungsgemäße Schaltungsanordnung anzugeben, die ohne Steuerlogik auskommt und keine Dekodiereinrichtung für den Skalenfaktor benötigt und damit leicht aufzubauen ist.

Diese erfindungsgemäße Aufgabe wird durch die Merkmale des Anspruchs 1 gelöst.

Eine besonders bevorzugte Weiterbildung der Erfindung ist im Anspruch 2 angegeben. Diese Weiterbildung ist dazu geeignet, die nach dem eingangserwähnten Normvorschlag übertragenen Tonsignaldaten bei Satelliten-Direkt-Rundfunk, wie er derzeit verwendet wird, also eine 16/14-Bit-Gleitkommatechnik vorzusehen.

Die Erfindung wird im folgenden anhand eines Ausführungsbeispieles im Zusammenhang mit drei Figuren näher erläutert. Es zeigen:
- FIG 1: eine Ausführungsform der erfindungsgemäßen Schaltungsanordnung für ein Umwandeln von digitalen 14-Bit-Signalen in ein 16-Bit-Signal, wie es im Satelliten-Direkt-Rundfunk verwendet wird;
- FIG 2: eine Signalwahrheitstabelle, wie sie für in FIG 1 ausschließlich vorgesehene Multiplexereinrichtungen gilt; und
- FIG 3: die Schaltungsanordnung von FIG 1, bei der beispielhaft ein 14-Bit-Signal an Eingangsklemmen anliegt.

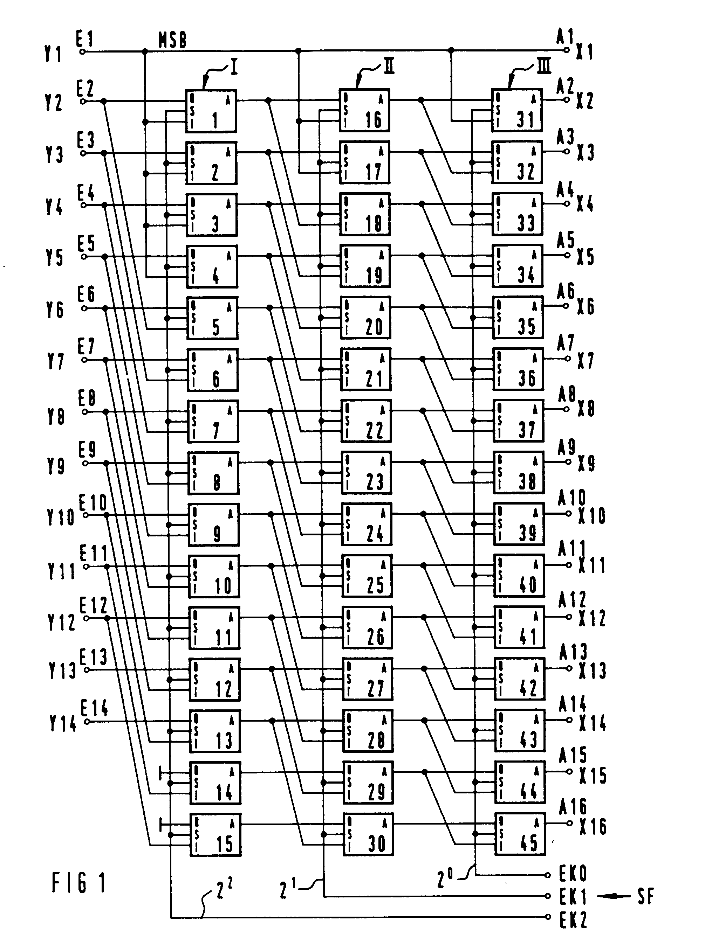

In FIG 1 ist eine erfindungsgemäße Schaltungsanordnung zum Umwandeln von digitalen Tonsignalen in ihr ursprüngliches Datenformat dargestellt, wobei die Tonsignale mit einem gemeinsamen digitalen Skalenfaktor zum Einsparen redundanter Bit-stellen im digitalen Tonsignal empfangen werden. Der Skalenfaktor ist ein digitales 3-Bit-Wort und mit SF bezeichnet. Die cinzelnen Bitstellen dieses Skalenfaktors SF werden an Eingangsklemmen EK0, EK1 und EK2 für das niederwertigste Bit 2⁰, das nächstfolgende Bit 2¹ und das höchstwertigste Bit 2² gekennzeichnet.

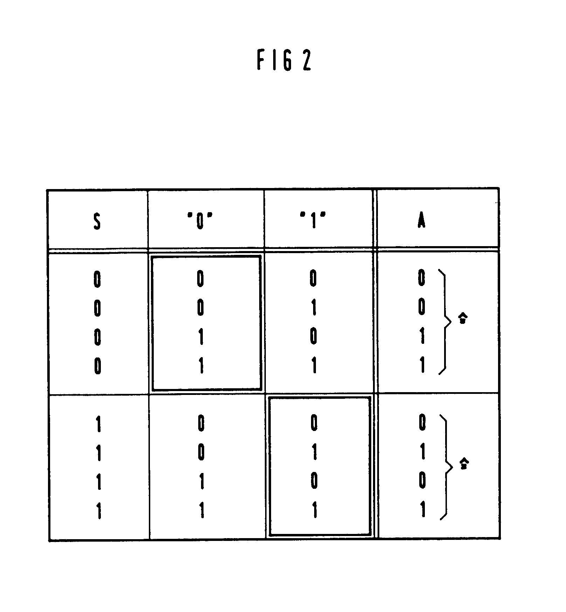

Die Schaltungsanordnung weist ausschließlich Multiplexereinrichtungen 1 bis 45 auf, deren Funktionsweise weiter unten anhand der Wahrheitstabelle in FIG 2 noch eingehend erläutert wird. Sämtliche Multiplexereinrichtungen 1 bis 45 werden jeweils von einer Bitstelle 2², 2¹, 2⁰ des Skalenfaktors SF gesteuert und damit mit einer deren Eingangsklemmen EK2, EK1 bzw. EK0 verbunden. Sämtliche Multiplexereinrichtungen 1 bis 45 erhalten als Eingangssignale Informationsbits Y1 bis Y14 des digitalen Tonsignales bzw. Ausgangssignale A1 bis A30 von vorgeschalteten Multiplexereinrichtungen 1 bis 30. An Ausgängen eines letzten Satzes von Multiplexereinrichtungen 31 bis 45 ist ein dekomprimiertes digitales Tonsignal, das die Informationsbits X1 bis X16 aufweist, an Ausgangsklemmen A1 bis A16 abgreifbar.

Zum Dekomprimieren und damit Umwandeln der digitalen Tonsignalen, die über Satelliten-Direkt-Rundfunk nach der eingangserwähnten Norm übertragen werden, weist die erfindungsgemäße Schaltungsanordnung folgende Merkmale auf:
- ein erster Satz (I) von Multiplexereinrichtungen (1 bis 15);
- ein zweiter Satz (II) von Multiplexereinrichtungen (16 bis 30);
- ein dritter Satz (III) von Miltiplexereinrichtungen (31 bis 45);
- jeder der Multiplexereinrichtungen (1 bis 45) weist einen ersten Eingang 0, einen zweiten Eingang 1, einen Setzeingang S sowie einen Ausgang A auf;
- Eingangsklemmen E1 bis E14 zum bitweisen Anlegen der Informationsbits (Y1 bis Y14) des digitalen Tonsignals;
- Eingangsklemmen (EK0, EK1, EK2) zum bitweisen Anlegen der Bits (2⁰, 2¹, 2²) des digitalen Skalenfaktors SF;
- Ausgangsklemmen (A1 bis A16) zum Abgreifen des umgewandelten digitalen Tonsignales, wobei die erste Ausgangsklemme (A1) mit der ersten Eingangsklemme (E1) und die übrigen Ausgangsklemmen (A2 bis A16) jeweils mit einem der Ausgänge A des dritten Satzes der Multiplexereinrichtungen (31 bis 45) verbunden sind; und
- die Multiplexereinrichtungen (1 bis 45) wie folgt verschaltet sind:
   - die erste Eingangsklemme El zum Anlegen des höchstwertigen Informationsbits (Y1) des digitalen Tonsignales ist mit der Ausgangsklemme Al für das höchstwertigste Informationsbit (X1) des dekomprimierten digitalen Tonsignales verbunden;
   - die Eingangsklemmen E2 bis E14 zum Anlegen der Informationsbits Y2 bis Y14 sind jeweils mit einem ersten Eingang 0 des ersten Satzes der Multiplexereinrichtungen (1 bis 13) verbunden und die Multiplexereinrichtung (14) und Multiplexereinrichtung (15) liegen mit ihren ersten Eingängen 0 auf Bezugspotential;
   - die Setzeingänge S des ersten Satzes der Multiplexereinrichtungen (1 bis 15) sind mit der Eingangsklemme (EK2) für das höherwertigste Bit (2²) des Skalenfaktors SF verbunden;
   - die zweiten Eingänge 1 der ersten bis vierten Multiplexereinrichtung (1 bis 4) sind mit der ersten Eingangsklemme (E1) und die zweiten Eingänge (1) der fünften bis fünfzehnten Multiplexereinrichtungen (5 bis 15) jeweils mit einer Eingangsklemme (E2 bis E12) verbunden;
   - jede Ausgangsklemme (A) des ersten Satzes der Multiplexereinrichtung (1 bis 15) ist mit einem ersten Eingang 0 des zweiten Satzes der Multiplexereinrichtungen (16 bis 30) in Verbindung;
   - die Setzeingänge S des zweiten Satzes der Multiplexereinrichtungen (16 bis 30) sind mit der Eingangsklemme (EK1) für das zweithöchstwertige Bit (2¹) des Skalenfaktors (SF) verbunden;
   - die zweiten Eingänge 1 der sechzehnten und siebzehnten Multiplexereinrichtungen (16, 17) sind mit der ersten Eingangsklemme E1 und die achzehnten bis dreißigsten Multiplexereinrichtungen (18 bis 30) des zweiten Satzes der Multiplexereinrichtungen (16 bis 30) mit jeweils einem Ausgang (A) der ersten bis dreizehnten Multiplexereinrichtungen (1 bis 13) des ersten Satzes der Multiplexereinrichtung (1 bis 15) verbunden;
   - jede Ausgangsklemme A des zweiten Satzes der Multiplexereinrichtung (16 bis 30) ist mit einem ersten Eingang 0 des dritten Satzes der Multiplexereinrichtung (31 bis 45) in Verbindung;
   - die Setzeingänge S des dritten Satzes der Multiplexereinrichtungen (31 bis 45) sind mit der Eingangsklemme (EK0) für das niederwertigste Bit (2⁰) des Skalenfaktors (SF) verbunden; und
   - die zweiten Eingänge 1 der zweiunddreißigsten bis fünfundvierzigsten Multiplexereinrichtungen (32 bis 45) des dritten Satzes der Multiplexereinrichtung (31 bis 45) sind mit den jeweils einem Ausgang (A) der sechzehnten bis neunundzwanzigsten Multiplexereinrichtungen (16 bis 29) des zweiten Satzes der Multiplexereinrichtungen (16 bis 30) und der Eingang der einunddreißigsten Multiplexereinrichtung (31) mit der ersten Eingangsklemme (E1) in Verbindung.

In FIG 2 ist eine Wahrheitstabelle für eine erfindungsgemäß zu verwendende Multiplexereinrichtung dargestellt. Sämtliche Multiplexereinrichtungen sind identisch aufgebaut. Jede Multiplexereinrichtung weist, wie im Zusammenhang mit FIG 1 bereits erwähnt, einen ersten Eingang 0, einen zweiten Eingang 1, einen Setzeingang S sowie einen Ausgang A auf. Je nach dem, ob der Setzeingang auf logisch "0" oder logisch "1" liegt, wird der Ausgang A der Multiplexereinrichtung MUX so geschaltet, daß das am ersten Eingang "0" anliegende Signal an den Ausgang A geschaltet wird oder dessen Signal am zweiten Eingang 1. Für dieses Ausführungsbeispiel heißt dies, daß bei einem Signal am Setzeingang S von logisch "0" der Ausgang A der entsprechenden Multiplexereinrichtung A das Signal ausgibt, das an der ersten Eingangsklemme dieser Multiplexereinrichtung MUX anliegt. Im umgekehrten Fall, daß am Setzeingang S eine logische "1" ansteht, wird das am zweiten Eingang 1 der Multiplexereinrichtung MUX anliegenden Signal an dessen Ausgang A geschaltet. Die dazugehörende Wahrheitstabelle ist im einzelnen in FIG 2 gezeigt.

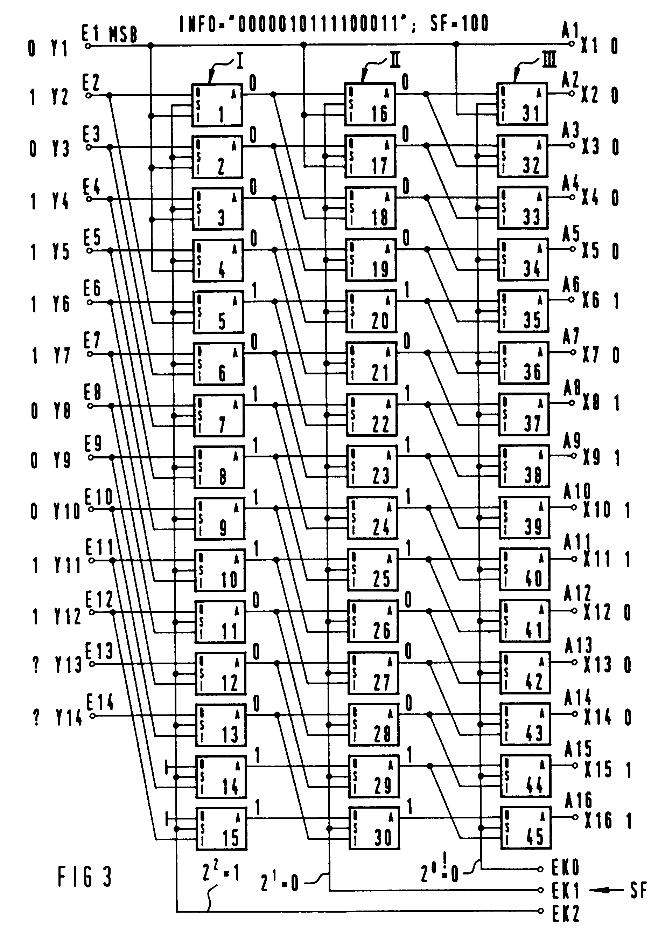

Wendet man diese Erkenntnis der Wahrheitstabelle der Multiplexereinrichtung MUX auf die in FIG 1 dargestellte Schaltungsanordnung an, so ist leicht zu erkennen, daß die erfindungsgemäße Schaltungsanordnung zum Umwandeln der digitalen Tonsignale geeignet ist. In FIG 3 ist zur Verdeutlichung das Umwandeln eines an den Eingangsklemmen Y1 bis Y12 anliegenden digitalen Tonsignales mit den Informationsbits "010111100011zz" mit einem Skalenfaktor SF = "100" dargestellt (zz sind beim Satelittenrundfunk zusätzliche Informationsbits). Wie der FIG 3 zu entnehmen ist, ist an den Ausgangsklemmen Al bis A16 das dekomprimierte umgewandelte digitale Tonsignal abgreifbar, das in diesem Ausführungsbeispiel die Informationsbits "0000010111100011" enthält.

Mit der vorliegenden Erfindung wird der Vorteil erreicht, daß ausschließlich identische Multiplexereinrichtungen vorgesehen sind, die keinerlei Steuerlogik benötigen. Die komplette Schaltung besteht aus nur insgesamt 45 2/1-Multiplexereinrichtungen MUX, die, beispielsweise in Form einer integrierten Schaltung äußerst platzsparend aufgebaut werden kann.

## Patentansprüche

1. Schaltungsanordnung zum Umwandeln von digitalen Tonsignalen, die mit einem gemeinsamen digitalen Skalenfaktor zum Einsparen redundanter Bitstellen im digitalen Tonsignal empfangen werden, in ihr ursprüngliches Datenformat durch Verschieben der Wertigkeit, **dadurch gekennzeichnet,**
daß zur Umwandlung ausschließlich Multiplexereinrichtungen (1 bis 45) mit jeweils zwei Eingängen, einem Ausgang und einem Setzeingang vorgesehen sind, daß die Multiplexereinrichtungen (1 bis 45) in verschiedenen hintereinandergeschalteren Sätzen (I, II, III) angeordnet sind und jeder dieser Sätze (I, II, II) über jeweils ein Bit (EK0, EK1, EK2) des Skalenfaktors (SF) steuerbar ist, daß einem ersten Satz (I) der Multiplexereinrichtungen (1 bis 45) als Eingangssignale Informationsbits (Y1 bis Y14) des digitalen Tonsignals bzw und den weiteren Sätzen (II, III) Ausgängssignale (A1 bis A30) von vorgeschalteten Multiplexereinrichtungen (1 bis 30) zugeführt werden, daß an Ausgängen eines letzten Satzes (III) von Multiplexereinrichtungen (31 bis 45) ein dekomprimiertes digitales Tonsignal abgegriffen wird, und daß Eingangsklemmen (E1 bis E14) zum bitweisen Anlegen der Informationsbits (Y1 bis Y14) des digitalen Tonsignals vorgesehen sind, wobei eine erste Eingangsklemme (E1) zum Anlegen des höchstwertigen Informationsbits (Y1) des digitalen Tonsignals mit der Ausgangsklemme (A1) für das höchstwertige Informationsbit (X1) des dekomprimierten digitalen Tonsignals und mit einem Eingang wenigstens einer der Multiplexereinrichtungen (1, 16, 31) aus jedem Satz (I, II, III) der Multiplexereinrichtungen (1 bis 45) verbunden ist.

2. Schaltungsanordnung nach Anspruch 1,
**dadurch gekennzeichnet,**
daß vorgesehen ist,
- ein erster Satz (I) von Multiplexereinrichtungen (1 bis 15);
- ein zweiter Satz (II) von Multiplexereinrichtungen (16 bis 30);
- ein dritter Satz (III) von Multiplexereinrichtungen (31 bis 45);
- Eingangsklemmen (EK0, EK1, EK2) zum bitweisen Anlegen der Bits (2⁰, 2¹, 2²) des digitalen Skalenfaktors SF;
- Ausgangsklemmen (A1 bis A16) zum Abgreifen des umgewandelten digitalen Tonsignales, wobei die erste Ausgangsklemme (Al) mit der ersten Eingangsklemme (E1) und die übrigen Ausgangsklemmen (A2 bis A16) jeweils mit einem der Ausgänge A des dritten Satzes der Multiplexereinrichtungen (31 bis 45) verbunden sind; und
- die Multiplexereinrichtungen (1 bis 45) wie folgt verschaltet sind:
- die Eingangsklemmen (E2 bis E14) zum Anlegen der Informationsbits (Y2 bis Y14) sind jeweils mit einem ersten Eingang (0) des ersten Satzes der Multiplexereinrichtungen (1 bis 13) verbunden und die Multiplexereinrichtung (14) und Multiplexereinrichtung (15) liegen mit ihren ersten Eingängen 0 auf Bezugspotential;
- die Setzeingänge S des ersten Satzes der Multiplexereinrichtungen (1 bis 15) sind mit der Eingangsklemme (EK2) für das höherwertigste Bit (2²) des Skalenfaktors SF verbunden;
- die zweiten Eingänge 1 der ersten bis vierten Multiplexereinrichtung (1 bis 4) sind mit der ersten Eingangsklemme (E1) und die zweiten Eingänge (1) der fünften bis fünfzehnten Multiplexereinrichtungen (5 bis 15) jeweils mit einer Eingangsklemme (E2 bis E12) verbunden;
- jede Ausgangsklemme (A) des ersten Satzes der Multiplexereinrichtung (1 bis 15) ist mit einem ersten Eingang 0 des zweiten Satzes der Multiplexereinrichtungen (16 bis 30) in Verbindung;
- die Setzeingänge S des zweiten Satzes der Multiplexereinrichtungen (16 bis 30) sind mit der Eingangsklemme (EK1) für das zweithöchstwertige Bit (2¹) des Skalenfaktors (SF) verbunden;
- die zweiten Eingänge 1 der sechzehnten und siebzehnten Multiplexereinrichtungen (16, 17) sind mit der ersten Eingangsklemme E1 und die achzehnten bis dreißigsten Multiplexereinrichtungen (18 bis 30) des zweiten Satzes der Multiplexereinrichtungen (16 bis 30) mit jeweils einem Ausgang (A) der ersten bis dreizehnten Multiplexereinrichtungen (1 bis 13) des ersten Satzes der Multiplexereinrichtung (1 bis 15) verbunden;
- jede Ausgangsklemme A des zweiten Satzes der Multiplexereinrichtung (16 bis 30) ist mit einem ersten Eingang 0 des dritten Satzes der Multiplexereinrichtung (31 bis 45) in Verbindung;
- die Setzeingänge S des dritten Satzes der Multiplexereinrichtungen (31 bis 45) sind mit der Eingangsklemme (EK0) für das niederwertigste Bit (2⁰) des Skalenfaktors (SF) verbunden; und
- die zweiten Eingänge 1 der zweiunddreißigsten bis fünfundvierzigsten Multiplexereinrichtungen (32 bis 45) des dritten Satzes der Multiplexereinrichtung (31 bis 45) sind mit den jeweils einem Ausgang (A) der sechzehnten bis neunundzwanzigsten Multiplexereinrichtungen (16 bis 29) des zweiten Satzes der Multiplexereinrichtungen (16 bis 30) und der Eingang der einunddreißigsten Multiplexereinrichtung (31) mit der ersten Eingangsklemme (E1) in Verbindung.

## Claims

1. Circuit arrangement for converting digital audio signals, which are received with a common digital scale factor in order to save redundant bit positions in the digital audio signal, into their original data format by shifting the significance, characterized in that for the conversion, provision is made exclusively of multiplexer devices (1 to 45) each having two inputs, one output and a set input, in that the multiplexer devices (1 to 45) are arranged in different cascaded banks (I, II, III) and each of these banks (I, II, III) can be controlled by means of a respective bit (EK0, EK1, EK2) of the scale factor (SF), in that as input signals, information bits (Y1 to Y14) of the digital audio signal are fed to a first bank (I) of the multiplexer devices (1 to 45) and output signals (A1 to A30) of upstream-connected multiplexer devices (1 to 30) are fed to the other banks (II, III), in that a decompressed digital audio signal is picked off at outputs of a last bank (III) of multiplexer devices (31 to 45), and in that provision is made of input terminals (E1 to E14) for the bit-by-bit application of the information bits (Y1 to Y14) of the digital audio signal, a first input terminal (E1) for the application of the most significant information bit (Y1) of the digital audio signal being connected to the output terminal (A1) for the most significant information bit (X1) of the decompressed digital audio signal and to an input of at least one of the multiplexer devices (1, 16, 31) from each bank (I, II, III) of the multiplexer devices (1 to 45).

2. A circuit arrangement according to Claim 1, characterized in that provision is made of
- a first bank (I) of multiplexer devices (1 to 15);
- a second bank (II) of multiplexer devices (16 to 30);
- a third bank (III) of multiplexer devices (31 to 45);
- input terminals (EK0, EK1, EK2) for the bit-by-bit application of the bits (2⁰, 2¹, 2²) of the digital scale factor SF;
- output terminals (A1 to A16) for picking off the converted digital audio signal, the first output terminal (A1) being connected to the first input terminal (E1), and the remaining output terminals (A2 to A16) being respectively connected to one of the outputs A of the third bank of multiplexer devices (31 to 45); and
- the multiplexer devices (1 to 45) are connected up as follows:
- the input terminals (E2 to E14) for the application of the information bits (Y2 to Y14) are respectively connected to a first input (0) of the first bank of multiplexer devices (1 to 13), and the multiplexer device (14) and multiplexer device (15) have their first inputs 0 connected to reference-earth potential;
- the set inputs S of the first bank of multiplexer devices (1 to 15) are connected to the input terminal (EK2) for the most significant bit (2²) of the scale factor SF;
- the second inputs 1 of the first to fourth multiplexer devices (1 to 4) are connected to the first input terminal (E1), and the second inputs (1) of the fifth to fifteenth multiplexer devices (5 to 15) are respectively connected to an input terminal (E2 to E12);
- each output terminal (A) of the first bank of multiplexer devices (1 to 15) is connected to a first input 0 of the second bank of multiplexer devices (16 to 30);
- the set inputs S of the second bank of multiplexer devices (16 to 30) are connected to the input terminal (EK1) for the second most significant bit (2¹) of the scale factor (SF);
- the second inputs 1 of the sixteenth and seventeenth multiplexer devices (16, 17) are connected to the first input terminal E1, and the eighteenth to thirtieth multiplexer devices (18 to 30) of the second bank of multiplexer devices (16 to 30) are respectively connected to an output (A) of the first to thirteenth multiplexer devices (1 to 13) of the first bank of multiplexer devices (1 to 15);
- each output terminal A of the second bank of multiplexer devices (16 to 30) is connected to a first input 0 of the third bank of multiplexer devices (31 to 45);
- the set inputs S of the third bank of multiplexer devices (31 to 45) are connected to the input terminal (EK0) for the least significant bit (2⁰) of the scale factor (SF); and
- the second inputs 1 of the thirty-second to forty-fifth multiplexer devices (32 to 45) of the third bank of multiplexer devices (31 to 45) are connected to a respective output (A) of the sixteenth to twenty-ninth multiplexer devices (16 to 29) of the second bank of multiplexer devices (16 to 30), and the input of the thirty-first multiplexer device (31) is connected to the first input terminal (E1).

## Revendications

1. Montage pour convertir en leur format de données initial, par décalage du poids, des signaux audio numériques qui sont reçus en ayant un facteur de cadrage numérique commun, afin d'économiser des emplacements de bits redondants dans le signal audio numérique, caractérisé en ce que, pour la conversion, il est prévu exclusivement des dispositifs (1 à 45) multiplexeurs comportant chacun deux entrées, une sortie et une entrée d'activation, en ce que les dispositifs (1 à 45) multiplexeurs sont disposés en divers ensembles (I,II,III) montés en série et en ce que chacun de ces ensembles (I,II,III) peut être commandé par l'intermédiaire d'un bit (EK0, EK1, EK2) du facteur (SF) de cadrage, en ce qu'il est envoyé un premier ensemble (I) des dispositifs (1 à 45) multiplexeurs, comme signaux d'entrée, des bits (Y1 à Y14) d'information du signal audio numérique et en ce qu'il est envoyé aux ensembles (II, III) supplémentaires des signaux (A1 à A30) de sortie provenant de dispositifs (1 à 30) multiplexeurs en amont, en ce qu'il est prélevé à des sorties d'un dernier ensemble (III) de dispositifs (31 à 45) multiplexeurs un signal audio numérique décompressé et en ce qu'il est prévu des bornes (E1 à E14) d'entrée pour appliquer bit à bit, les bits (Y1 à Y14) d'information du signal audio numérique, une première borne (E1) d'entrée servant à appliquer le bit (Y1) d'information de plus grand poids du signal audio numérique étant relié à la borne (A1) de sortie prévue pour le bit (X1) d'information de plus grand poids du signal audio numérique décompressé et à une entrée d'au moins l'un des dispositifs (1,16,31) multiplexeurs de chaque ensemble (I,II,III) des dispositifs (1 à 45) multiplexeurs.

2. Montage suivant la revendication 1, caractérisé en ce qu'il est prévu
- un premier ensemble (I) de dispositifs de (1 à 15) multiplexeurs;
- un deuxième ensemble (II) de dispositifs de (16 à 30) multiplexeurs;
- un troisième ensemble (III) de dispositifs de (31 à 45) multiplexeurs;
- des bornes (EK0, EK1, EK2) d'entrée pour appliquer bit à bit les bits (2⁰, 2¹, 2²) du facteur (SF) de cadrage numérique;
- des bornes (A1 à A16) de sortie pour prélever le signal audio numérique converti, la première borne (A1) de sortie étant reliée à la première borne (E1) d'entrée et les bornes (A2 à A16) de sortie restantes étant reliées chacune à une des sorties (A) du troisième ensemble des dispositifs (31 à 35) multiplexeurs; et
- les dispositifs (1 à 45) multiplexeurs sont branchés comme suit :
- les bornes (E2 à E14) d'entrée servant à appliquer les bits (Y2 à Y14) d'information sont reliées chacune à une première entrée (0) du premier ensemble des dispositifs (1 à 13) multiplexeurs et le dispositif (14) multiplexeur et le dispositif (15) multiplexeur sont au potentiel de référence par leur première entrée (0),
- les entrées (S) d'activation du premier ensemble des dispositifs (1 à 15) multiplexeurs sont reliées à la borne (EK2) prévue pour le bit (2²) de plus grand poids du facteur (SF) de cadrage ;
- les deuxièmes entrées 1 des premier à quatrième dispositif (1 à 14) multiplexeur sont reliées à la première borne (E1) d'entrée et les deuxièmes entrées (I) des cinquième à quinzième dispositifs (5 à 15) multiplexeurs sont reliées chacun à une borne (E2 à E12) d'entrée ;
- chaque borne (A) de sortie du premier ensemble des dispositifs (1 à 15) multiplexeurs est en liaison avec un première entrée 0 du deuxième ensemble des dispositifs (16 à 30) multiplexeurs ;
- les entrées (S) d'activation du deuxième ensemble des dispositifs (16 à 30) multiplexeurs sont reliées à la borne (EK1) d'entrée prévue pour le bit de puissance (1 ) de deuxième plus grand poids du facteur (SF) de cadrage ;
- les deuxièmes entrées 1 des seizième et dix-septième dispositifs (16,17) multiplexeurs sont reliées à la première borne E1 d'entrée et les dix-huitième à trentième dispositifs (18 à 30) multiplexeurs du deuxième ensemble des dispositifs (16 à 30) multiplexeurs sont reliés chacun à une sortie (A) du premier au treizième dispositif (1 à 13) multiplexeur du premier ensemble des dispositifs (1 à 15) multiplexeurs ;
- chaque borne A de sortie du deuxième ensemble des dispositifs (16 à 30) multiplexeurs est en liaison avec une première entrée 0 du troisième ensemble des dispositifs (31 à 45) multiplexeurs;
- l'entrée (S) d'activation du troisième ensemble des dispositifs (31 à 45) multiplexeurs sont reliés à la borne (EK0) d'entrée prévue pour le bit (2⁰) de plus petit poids de facteur (SF) de cadrage; et
- les deuxième entrées 1 des trente-deuxième à quarante-cinquième dispositifs (32 à 45) multiplexeurs du troisième ensemble de dispositifs (31 à 45) multiplexeurs du troisième ensemble de dispositif (31 à 45) multiplexeur sont reliés chacun à l'une des sorties (A) des seizième à vingt-neuvième dispositifs (16 à 29) multiplexeurs du deuxième ensemble des dispositifs (16 à 30) multiplexeurs et l'entrée du trente-et-unième dispositif multiplexeur est en liaison avec la première borne (E1) ) d'entrée.
